# EUROPÄISCHE PATENTSCHRIFT

(11) **EP 0 530 393 B1**
(45) Veröffentlichungstag und Bekanntmachung des Hinweises auf die Patenterteilung: **07.12.1994**
(21) Anmeldenummer: 91114771.8
(22) Anmeldetag: 02.09.1991
(51) Int. Cl.: H03L 7/07

(54) **Verfahren und Vorrichtung zur Synchronisation einer Takteinrichtung eines Fernmeldevermittlungssystems**
Method and apparatus for synchronising a clockcircuit of a switching communication system
Méthode et dispositif pour la synchronisation d'un générateur d'horloge d'un système de commutation de communication

(43) Veröffentlichungstag der Anmeldung: 10.03.1993
(73) Patentinhaber: SIEMENS AKTIENGESELLSCHAFT, 80333 München (DE)
(72) Erfinder: Hoffmann, Reinhold, Dr., W-8919 Utting (DE); Oberhauser, Walter, W-8190 Wolfratshausen (DE); Heitmann, Jürgen, Dr., W-8000 München 71 (DE); Geissler, Friedrich, W-8190 Wolfratshausen (DE)

(56) Entgegenhaltungen:
- EP-A- 0 084 002
- EP-A- 0 423 663
- WO-A-87/00369
- DE-A- 3 809 089
- PATENT ABSTRACTS OF JAPAN vol. 13, no. 558 12 December 1989
- IEEE COMMUNICATIONS MAGAZINE. vol. 19, no. 3, May 1981, NEW YORK, USA pages 12 - 21; KATSUYA OKIMI AND HIROSHI FUKINUKI: 'Master-slave synchronisation techniques.'
- PATENT ABSTRACTS OF JAPAN vol. 10, no. 384 (E-466)(2441) 23 December 1986
- PATENT ABSTRACTS OF JAPAN vol. 13, no. 352 8 August 1989

## Beschreibung

Die Erfindung betrifft ein Verfahren nach dem Oberbegriff des Anspruchs 1.

In synchronen digitalen Fernmeldenetzen werden zentrale Takteinrichtungen der einzelnen digitalen Vermittlungsstellen hierarchisch nach dem master/slave-Prinzip synchronisiert. Dabei wird für das gesamte Netz ein einziger frequenzbestimmender Taktgenerator (masterclock) vorgesehen. Alle anderen Taktgeneratoren werden auf seine Taktfrequenz synchronisiert. Dieses Verfahren birgt allerdings vor allem für größere Netze die Gefahr in sich, daß ein Fehler im zentralen Taktgeber das gesamte Netz zum Ausfall bringt. Zur Reduzierung der Störwirkbreite werden daher bei diesem Verfahren redundante Taktversorgungsleitungen vorgesehen und auch relativ genaue örtliche Taktgeneratoren eingesetzt, damit im Fehlerfall wenigstens mit noch akzeptabler Schlupfrate der Betrieb aufrechterhalten werden kann. (Bergmann, Lehrbuch der Fernmeldetechnik, Band 1, 5. Auflage, Berlin 1986, Seite 485).

Aus der europäischen Patentanmeldung EP-A-0391144 (veröffentlicht am 10. Oktober 1990) ist bereits ein Verfahren zur Synchronisation einer Takteinrichtung eines getakteten elektrischen Systems bekannt. Die Fernmeldevermittlungsstelle wird im Normalbetrieb von einer externen Referenzfrequenz synchronisiert und bei längerem Ausfall der externen Referenzfrequenz wird ein systeminternes Frequenz-Normal eingeschaltet, welches von der Takteinrichtung räumlich getrennt ist. Ist mehr als eine externe Referenzfrequenz verfügbar, wird das systeminterne Frequenz-Normal nur dann aktiviert, wenn sämtliche externen Referenzfrequenzen ausgefallen sind. Bei Ausfall der momentan benutzten externen Referenzfrequenz wird auf eine andere externe Referenzfrequenz umgeschaltet, wobei offen bleibt, in welcher Weise diese Umschaltung erfolgt, wenn bei Ausfall der momentan benutzten externen Referenzfrequenz mindestens zwei weitere externe Referenzfrequenzen verfügbar sind.

Aus der europäischen Patentanmeldung EP-A-0 423 663 ist bereits eine Takteinrichtung sehr großer Stabilität bekannt, die von externen Synchronisationssignalen synchronisiert wird. Die Synchronisation erfolgt in Abhängigkeit eines Prioritätsrangs der externen Signale und in Abhängigkeit intern gebildeter Signalqualitätsmerkmale. Bei der Auswahl eines externen Synchronisationssignals hat bei der bekannten Takteinrichtung die Priorität insoweit Vorrang gegenüber den genannten Qualitätsmerkmalen, als ein Signal geringerer Priorität nur dann ausgewählt wird, wenn das Signal höherer Priorität eine bestimmte Qualität unterschreitet. Die Qualitätsmerkmale der übrigen Signale sind insoweit für die Signalauswahl ohne Bedeutung.

Der Erfindung liegt daher die Aufgabe zugrunde, eine Takteinrichtung eines digitalen Fernmeldevermittlungssystems anzugeben, die bei Zufuhr mindestens zweier externer Referenzfrequenzen den Anforderungen an eine ausreichende Synchronisation soweit als möglich entspricht.

Diese Aufgabe wird bei einem Verfahren der eingangs genannten Art durch die kennzeichnenden Merkmale des Anspruchs 1 gelöst.

Als wesentlich für die Erfindung ist unter anderem anzusehen, daß die Auswahl einer von mehreren externen Referenztaktquellen nach zwei unterschiedlichen Kriterien erfolgt; eine von der voraussehbaren Güte der Referenztaktquelle bzw. der entsprechenden Übertragungsstrecke abhängige Priorität und von dem Auftreten von Fehlern im laufenden Betrieb. Damit kann die momentan jeweils beste Referenztaktquelle für die Synchronisation der Takteinrichtung verwendet werden. Das erfindungsgemäße Verfahren ist in soweit nur bedingt von der vorgegebenen Referenztaktquellenpriorität abhängig; fehlerrelevanten Zustandsänderungen der jeweiligen Referenztaktquelle bzw. der entsprechenden Übertragungsstrecken werden damit entsprochen.

In diesem Zusammenhang ist vorgesehen, daß die Takteinrichtung zu ihrer Synchronisation bei gleichen Prioritäten der Referenztaktquellen das von der ersten oder zweiten Referenztaktquelle abgegebene Referenztaktsignal mit geringerem taktfehlerindividuellen Fehlerwert übernimmt, und daß die Takteinrichtung bei unterschiedlichen Prioritäten der Referenztaktquellen das Referenztaktsignal der Referenztaktquelle höchster Priorität übernimmt, sofern das von dieser Referenztaktquelle zugeführte Referenztaktsignal einen vorgegebenen ersten Fehlergrenzwert nicht überschreitet, und daß bei einem Überschreiten des ersten Fehlergrenzwertes die Takteinrichtung das Referenztaktsignal der Referenztaktquelle nachgeordneter Priorität übernimmt, sofern das von der Referenztaktquelle nachgeordneter Priorität zugeführte Referenztaktsignal einen geringeren Fehlerwert als das Referenztaktsignal der Referenztaktsignal der Referenztaktquelle höchster Priorität aufweist.

Damit bleibt das Referenztaktsignal höchster Priorität für die Synchronisation der Takteinrichtung maßgeblich, selbst wenn der aktuelle Fehlerwert des Referenztaktsignals höchster Priorität größer ist als der aktuelle Fehlerwert des Referenztaktsignals nachgeordneter Priorität, sofern das Referenztaktsignal höchster Priorität den vorgegebenen ersten Fehlergrenzwert nicht überschreitet. Auf diese Weise wird die Anzahl vorzunehmender Referenztaktwechsel vermindert. Damit entfallen Synchronisierungsvorgänge, die je nach der Struktur des zugehörigen Fernmeldevermittlungssystems mehrere Minuten erfordern können, so daß die Langzeitstabilität des Fernmeldevermittlungssystems verbessert wird.

Diese Vorteile ergeben sich auch, wenn die Takteinrichtung zu ihrer Synchronisation bei gleichen oder unterschiedlichen Prioritäten der Referenztaktquellen das momentan übernommene Referenztaktsignal auch dann beibehält, wenn dieses Referenztaktsignal unter einem unteren zweiten Fehlergrenzwert liegt, und der aktuelle Fehlerwert des oder der nichtübernommenen Referenztaktsignale gleich dem aktuellen Fehlerwert des übernommenen Referenztaktsignals ist oder einen geringeren Wert als dieser aufweist.

Der Einfluß zeitlich zurückliegender Fehler wird dadurch verringert, daß die Fehlerwerte, die den der Takteinrichtung zugeführten Referenztaktsignalen zugeordnet sind, nach Ablauf vorgegebener Zeiteinheiten um einen vorgegebenen Wert vermindert werden.

Weitere vorteilhafte Ausgestaltungen sind in den Unteransprüchen gekennzeichnet und werden im folgenden anhand der Figuren beschrieben.

Es zeigt
- Fig. 1: ein Blockschaltbild einer Takteinrichtung;
- Fig. 2: das Blockschaltbild einer Takteinrichtung an die in einem Fernmeldevermittlungssystem eine Mehrzahl referenztaktliefernder Baugruppen angeschaltet ist;
- Fig. 3: ein Beispiel für den Inhalt eines Tabellenspeichers in einer Takteinrichtung nach Fig. 1 oder Fig. 2; und
- Fig. 4: eine Anordnung vernetzter Fernmeldevermittlungssysteme mit Takteinrichtungen nach Fig. 1 oder Fig. 2.

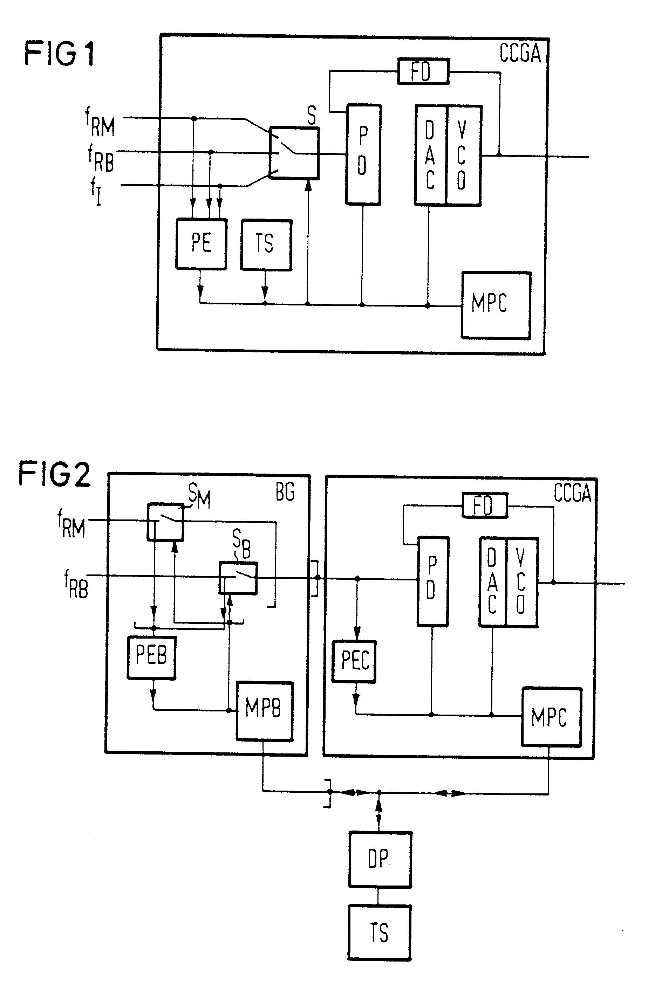

Die in Figur 1 dargestellte Takteinrichtung, insbesondere eines Fernmeldevermittlungssystems, umfaßt einen zentralen Taktgenerator CCGA, dem zwei externe Referenzfrequenzen f_{RM} und f_{RB} von einer in Fig. 1 nicht dargestellten ersten Referenztaktquelle M und einer zweiten externen Referenztaktquelle B zugeführt werden. Zusätzlich kann dem zentralen Taktgenerator CCGA eine interne Referenzfrequenz fI zugeführt werden, die beispielsweise von einer systeminternen Taktquelle geliefert wird.

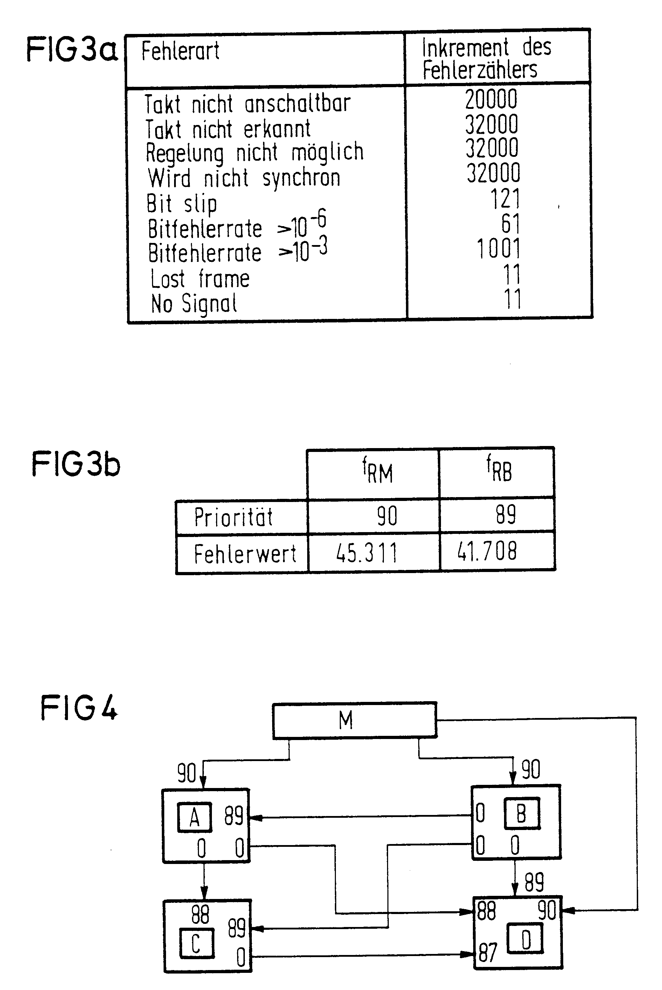

Die Eingänge des Taktgenerators CCGA sind durch einen von einem Mikroprozessor MPC gesteuerten Schalter umschaltbar. Die die externen Referenztaktsignale führenden Eingänge des Taktgenerators sind mit einer Einrichtung PE verbunden, die wie noch beschrieben wird, die zugeführten Referenztaktsignale auf Taktfehler überprüft und den Taktfehlern individuelle Fehlerwerte zuordnet. Diese Fehlerwerte werden in dem Tabellenspeicher TS individuell für jedes externe Referenztaktsignal verwaltet. Zusätzlich können im Tabellenspeicher TS die Prioritätswerte für diejenigen externen Referenztaktquellen abgelegt sein, die die entsprechenden Referenztaktsignale dem zen- tralen Taktgenerator CCGA zuführen. Im vorliegenden Fall beträgt, wie in Fig. 4 für die Einrichtung A dargestellt, der Prioritätswert der externen Referenztaktquelle M gleich 90 und der Prioritätswert der externen Referenztaktquelle B gleich 89.

Der Mikroprozessor MPC steuert die Regelung des Phasenregelkreises, der im weiteren aus einem Phasendiskriminator PD, einem Digital-Analog-Converter DAC, einem spannungsgesteuerten Oszilator VCO und einer Rückführungsschleife FD besteht, die die Ausgangsfrequenz des spannungsgesteuerten Oszilators VCO auf einen Eingang des Phasendiskriminators PD zurückführt.

Der Mikroprozessor MPC steuert den Schalter S einerseits in Abhängigkeit von der Einrichtung PE ermittelten referenztaktsignalindividuellen Taktfehler bzw. der den Taktfehlern zugeordneten Fehlerwerte und andererseits in Abhängigkeit von der vorgegebenen Priorität der externen Referenztaktquellen M und B (Fig. 4). Die Priorität der externen Referenztaktquellen wird entsprechend ihrer Taktgüte und der Qualität der Übertragungsstrecke von der jeweiligen Referenztaktquelle zum betrachteten zentralen Taktgenerator bestimmt. ISDN-Anschlüssen werden relativ hohe Prioritäten zugeordnet. Bei vernetzten Systemen (Fig. 4) ist die jeweilige Priorität von dem Netz abhängig an dem der zu der Takteinrichtung führende (Amts- oder Querverbindungs-) Satz angeschlossen ist, sowie von der Topologie des Fernmeldevermittlungssystems.

Die Einrichtung PE ermittelt in an sich bekannter Weise in Tabelle 3a aufgelistete Fehler "Takt nicht anschaltbar", "Bitschlupf (bit slip)", "Bitfehlerrate > 10 ⁻⁶", "Bitfehlerrate > 10 ⁻³", Rahmenverlust (lost frame) "kein Signal" (no signal). Die bit Fehlerraten werden mit Hilfe der CRC4-Prozedur nach CCITT G.704 bestimmt. Der Mikroprozessor MPC erkennt die Fehler "Takt nicht erkannt", "Regelung nicht möglich" und "wird nicht synchron".

Der Mikroprozessor MPC steuert den Schalter S insbesondere in der Weise, daß die Takteinrichtung bei unterschiedlichen Prioritäten (im vorliegenden Fall: Priorität der Referenztaktquelle M ist gleich 90, Priorität der Referenztaktquelle B ist gleich 89) das Referenztaktsignal f_{RM} der Referenztaktquelle M höchster Priorität übernimmt, sofern das von dieser Referenztaktquelle M zugeführte Referenztaktsignal f_{RM} einen (oberen) ersten Fehlergrenzwert nicht überschreitet. Bei einem Überschreiten dieses Fehlergrenzwertes, der beispielsweise auf den Wert 42.000 festgelegt wird, wird der Schalter S in der Weise gesteuert, daß die Takteinrichtung das Referenztaktsignal f_{RB} der Referenztaktquelle B nachgeordneter Priorität übernimmt, sofern das von dieser Referenztaktquelle B zugeführte Referenztaktsignal f_{RB} einen geringeren Fehlerwert als das Referenztaktsignal f_{RM} der Referenztaktquelle M höchster Priorität aufweist.

Für den Fall, daß Referenztaktquellen dieselbe Priorität aufweisen, schaltet der Mikroprozessor den Schalter S in der Weise, daß die Takteinrichtung das Referenztaktsignal mit geringerem taktfehlerindividuellen Fehlerwert übernimmt.

Das erfindungsgemäße Verfahren ist sowohl auf Takteinrichtungen anwendbar, denen ausschließlich Referenztaktsignale von Referenztaktquellen gleicher Priorität zugeführt werden, als auch auf Takteinrichtungen, denen Referenztaktsignale von einer Mehrzahl von Referenztaktquellen zugeführt werden, wobei nur eine Untermenge der Referenztaktquellen die gleiche Priorität aufweist.

Wenn ein zur Synchronisation der Takteinrichtung übernommenes Referenztaktsignal unter einem unteren zweiten Fehlergrenzwert von beispielsweise 16000 liegt und damit einen relativ geringen Fehlerwert aufweist, kann vorgesehen sein, daß das aktuell anliegende Referenztaktsignal auch dann beibehalten wird, wenn der Fehlerwert eines nichtübernommenen Referenztaktsignals bzw. die Fehlerwerte mehrerer nicht übernommener Referenztaktsignale einen gleichen oder geringeren Fehlerwert als der Fehlerwert des übernommenen Referenztaktsignals aufweisen. Damit haben die Prioritäten der Referenztaktquellen, die das von der Takteinrichtung übernommene bzw. die nichtübernommene Referenztaktsignale liefern, keinen Einfluß. Auf diese Weise wird, wie schon erwähnt, die Anzahl vorzunehmender Referenztaktwechsel vermindert.

Der Mikroprozessor MPC oder eine separate Steuerung der Einrichtung PE vermindert die den Referenztaktsignalen zugeordneten Fehlerwerte nach Ablauf vorgegebener Zeiteinheiten um einen vorgegebenen Wert, beispielsweise um 5% pro Stunde. Damit wird der Einfluß aufgetretener Fehler nach Ablauf vorgegebener Zeiträume gemindert und der Einfluß der vorgegebenen Referenztaktquellenprioritäten erhöht.

Fig. 2 zeigt eine zentrale Takteinrichtung an die in einem Fernmeldevermittlungssystem eine Mehrzahl referenztakt liefernder Baugruppen BG angeschaltet ist. Jede Baugruppe BG weist einen baugruppenindividuellen Prozessor MPB auf, der die aus der jeweiligen Baugruppe vorzunehmenden Steuervorgänge in verbindung mit einem zentralen Datenprozessor DP und dem Prozessor MPC des zentralen Taktgenerators durchführt. Jede Baugruppe kann beispielsweise Amts- oder Querverbindungssätze SM und SB aufweisen. Die externen Referenztaktsignale, z.B. f_{RM} und f_{RB}, sind jeweils über einen Schalter der Sätze SM bzw. SB an den zentralen Taktgenerator CCGA anschaltbar. Taktfehler werden in den Baugruppen jeweils von einer Einheit PEB und im zentralen Taktgenerator von einer Einheit PEC ermittelt. Die Einrichtungen PEB und PEC entsprechen der in Fig. 1 dargestellten Einrichtung PE.

Der Tabellenspeicher TS ist bei der vorliegenden Ausführungsform dem zentralen Datenprozessor DP zugeordnet.

In Fig. 3a sind ausgewählte Fehlerarten und ihnen zugeordnete Fehlerwerte aufgelistet. Dabei bedeutet die Fehlerart "Takt nicht anschaltbar" , daß das Referenztaktsignal wegen einer am zugehörigen Eingang anliegenden Störung nicht angeschaltet werden kann. Der Mikroprozessor MPC bzw. MPB erkennt die Fehlerart "Takt nicht erkannt", wenn an dem gerade angeschalteten Eingang kein Referenztaktsignal anliegt. Ferner erkennt der mit dem internen Regelkreis verbundende Mikroprozessor MPC die Fehlerart "Regelung nicht möglich". Diese Fehlerart liegt z.B. vor, wenn der interne Regelkreis (PD, DAC, VCO, FD) des zentralen Takgenerators CCGA defekt ist oder nur eingeschränkt arbeitet. Ferner erkennt er die Fehlerart "wird nicht synchron", wenn es trotz an sich hinreichend lange Regelungszeiten nicht gelingt, die geforderte Synchronität zu dem angeschalteten Referenztaktsignal herzustellen.

Wie anhand der Fig. 1 und 2 beschrieben, ermitteln die Einrichtung PE bzw. PEB und PEC sowie MPC,MPB betriebsbegleitend das Auftreten von Fehlern und ordnet den Fehlern vorgegebene Fehlerwerte zu, die in Fig. 3a aufgelistet sind. Dabei kann vorgesehen sein, daß der in dem Tabellenspeicher TS abgespeicherte referenztaktsignalindividuelle Fehlerzähler (Fig. 3b) bei Betriebsbeginn mit einem Fehlerwert 16.000 vorinitialisiert ist. Damit wird erreicht, daß bei der erfindungsgemäß vorgesehenen Verminderung des aktuellen Fehlerwertes nach Ablauf vorgegebener Zeiteinheiten um z.B. 5% pro Stunde der neugebildete Wert geringere, positive Werte als der Ausgangswert annehmen kann. Der Wert Null stellt den fehlerfreien Idealzustand dar.

Fig. 3b zeigt die im Tabellenspeicher TS abgelegte Tabelle. In dieser sind für jede Referenztaktquelle die vorgegebene Priorität sowie der aktuelle Fehlerstand abgespeichert. Im dargestellten Beispiel beträgt der aktuelle Fehlerwert der Referenztaktquelle M höherer Priorität (90) 45.311, während der aktuelle Fehlerwert der Referenztaktquelle B geringerer Priorität (89) 41.708 beträgt. Für den Fall, daß als oberer Fehlergrenzwert 42.000 festgelegt wird, schaltet der Mikroprozessor MP C den Schalter S von dem Eingang, der das Referenztaktsignal f_{RM} führt, auf den Eingang um, der das Referenztaktsignal f_{RB} führt. Werden nun im Referenztaktsignal f_{RB} Taktfehler erkannt, die den Fehlerwert auf einen neuen Fehlerwert von z.B. 46.000 erhöhen, der oberhalb des dann aktuellen Fehlerwerts von f_{RM} = 45.311 liegt, so schaltet der Mikroprozessor MPC den Schalter S wiederum auf den Eingang um, der das Referenztaktsignal f_{RM} führt.

In Fig. 4 ist eine Anordnung mehrerer Fernmeldevermittlungssysteme M, bzw. Takteinrichtungen A, B, C und D dargestellt, die untereinander wie in der Figur dargestellt vernetzt sind. Dabei bezeichnet M ein Vermittlungssystem mit der höchsten hierarchischen Stufe, beispielsweise ein öffentliches Amt oder eine private Nebenstellenanlage. Die Zahlen 90, 89, 88 und 87 bezeichnen unterschiedliche Prioritäten, die in Abhängigkeit von der Qualität der Referenztaktquelle, die Referenztaktsignale liefert, bzw. in Abhängigkeit von der Güte der jeweiligen Übertragungsstrecke vorgegeben werden. Dabei erhalten ISDN-Leitungen relativ hohe Prioritäten gegenüber anderen Leitungen. Priorität "0" bedeutet, daß von dieser Übertragungsstrecke kein Takt bezogen wird, sondern daß eine solche Strecke vielmehr ein möglicher Taktlieferant für das entsprechende Partnervermittlungssystem ist.

Geht man davon aus, daß alle in Fig. 4 dargestellten Strecken in Betrieb sind, synchronisiert sich das Vermittlungssystem A auf die Strecke mit der Priorität 90, ebenso die Vermittlungssysteme B und D. Das Vermittlungssystem C synchronisiert sich auf die Strecke mit der Priorität 89. Fällt das "Master"-Vermittlungssystem M aus, übernimmt das System B die Masterfunktion. A, C, D synchronisieren sich auf B auf. Fällt auch B aus, wird A Master. Fällt auch A aus, wird C Master.

## Patentansprüche

1. Verfahren zur Synchronisation einer Takteinrichtung (A) eines Fernmeldevermittlungssystems, der zumindest zeitweise von einer ersten und einer zweiten externen Referenztaktquelle (M,B) erste und zweite Referenztaktsignale (f_{RM}, f_{RB}) zugeführt werden, wobei jeder externen Referenztaktquelle (M,B) eine vorgegebene Priorität zugeordnet ist, wobei die der Takteinrichtung (A) von der ersten und zweiten Referenztaktquelle (M,B) zugeführten ersten und zweiten Referenztaktsignale (f_{RM}, f_{RB}) auf erste und zweite referenztaktindividuelle Taktfehler überprüft werden, denen taktfehlerindividuelle Fehlerwerte zugeordnet werden, und wobei die Takteinrichtung (A) zu ihrer Synchronisation das von der ersten oder zweiten Referenztaktquelle (M,B) abgegebene Referenztaktsignal (f_{RM}, f_{RB}) in Abhängigkeit der den Referenztaktquellen (M,B) zugeordneten Prioritäten und den taktfehlerindividuellen Fehlerwerten übernimmt,
**dadurch gekennzeichnet,**
daß die Takteinrichtung (A) zu ihrer Synchronisation bei gleichen Prioritäten der Referenztaktquellen (M,B) das von der ersten oder zweiten Referenztaktquelle (M,B) abgegebene Referenztaktsignal (f_{RM}, f_{RB}) mit geringerem taktfehlerindividuellen Fehlerwert übernimmt, und daß die Takteinrichtung (A) bei unterschiedlichen Prioritäten der Referenztaktquellen (M,B) das Referenztaktsignal (f_{RM},f_{RB}) der Referenztaktquelle (M) höchster Priorität übernimmt, sofern das von dieser Referenztaktquelle (M) zugeführte Referenztaktsignal (f_{RM}) einen vorgegebenen oberen ersten Fehlergrenzwert nicht überschreitet, und daß bei einem Überschreiten dieses Fehlerschwellwertes die Takteinrichtung das Referenztaktsignal (f_{RB}) der Referenztaktquelle (B) nachgeordneter Priorität übernimmt, sofern das von der Referenztaktquelle (B) nachgeordneter Priorität zugeführte Referenztaktsignal (f_{RB}) einen geringeren Fehlerwert als das Referenztaktsignal (f_{RM}) der Referenztaktquelle (M) höchster Priorität aufweist.

2. Verfahren nach Anspruch 1,
**dadurch gekennzeichnet,**
daß die Takteinrichtung (A) zu ihrer Synchronisation bei gleichen oder unterschiedlichen Prioritäten der Referenztaktquellen (M,B) das von der momentan aktivierten Referenztaktquelle (B,M) abgegebene Referenztaktsignal (f_{RB},f_{RM}) auch dann beibehält, wenn der Fehlerwert dieses Referenztaktsignal unter einem unteren, zweiten Fehlergrenzwert liegt und der Fehlerwert des oder der anderen Referenztaktsignale einen gleichen oder geringeren Wert aufweisen.

3. Verfahren nach einem der vorstehenden Ansprüche,
**dadurch gekennzeichnet,**
daß die Fehlerwerte, die den der Takteinrichtung (A) zugeführten Referenztaktsignalen (f_{RM}, f_{RB}) zugeordnet sind nach Ablauf vorgegebener Zeiteinheiten um einen vorgegebenen Wert vermindert werden.

4. Vorrichtung zur Durchführung des Verfahrens nach einem der vorstehende Ansprüche,
**bestehend aus**
der Takteinrichtung (A) mit
einer Einrichtung (PE) zur Überprüfung der zugeführten Referenztaktsignale (f_{RM}, f_{RB}) auf Taktfehler und zur Bewertung der Taktfehler,
einem Tabellenspeicher (TS) zur Aufnahme der Fehlerwerte und einer Steuerung (MPC), der ein Programm zur Durchführung des Verfahrens zugeordnet ist.

5. Vorrichtung nach Anspruch 4,
**dadurch gekennzeichnet,**
daß die Takteinrichtung (A) in Verbindung mit einer Übertragungsstrecke zu einer Takteinrichtung eines weiteren Fernmeldevermittlungssystems (B) eine Referenztaktquelle für diese Takteinrichtung bildet.

## Claims

1. Method for synchronizing a clock circuit (A) of a telecommunications exchange, to which first and second reference clock signals (f_{RM}, f_{RB}) are supplied at least occasionally from a first and a second external reference clock source (M, B), in which a predetermined priority is assigned to each external reference clock source (M, B), in which the first and second reference clock signals (f_{RM}, f_{RB}) supplied to the clock circuit (A) from the first and second reference clock source (M, B) are tested for first and second reference-clock-specific clock errors to which clock-error-specific error values are assigned, and in which, for its synchronization, the clock circuit (A) transfers the reference clock signal (f_{RM}, f_{RB}) output by the first or second reference clock source (M, B) depending on the priorities assigned to the reference clock sources (M, B) and the clock-error-specific error values, characterized in that, for its synchronization, the clock circuit (A) transfers the reference clock signal (f_{RM}, f_{RB}) output by the first or second reference clock source (M, B) having a lower clock-error-specific error value given identical priorities of the reference clock sources (M, B), and in that the clock circuit (A) transfers the reference clock signal (f_{RM}, f_{RB}) of the reference clock source (M) having the highest priority given different priorities of the reference clock sources (M, B), provided that the reference clock signal (f_{RM}) supplied from said reference clock source (M) does not exceed a predetermined upper first error limit value, and in that if said error threshold value is exceeded, the clock circuit transfers the reference clock signal (f_{RB}) of the reference clock source (B) having the lower priority, provided that the reference clock signal (f_{RB}) supplied from the reference clock source (B) having the lower priority has a lower error value than the reference clock signal (f_{RM}) of the reference clock source (M) having the highest priority.

2. Method according to Claim 1, characterized in that, for its synchronization, the clock circuit (A) retains the reference clock signal (f_{RB}, f_{RM}) output by the currently activated reference clock source (B, M) given identical or different priorities of the reference clock sources (M, B) even if the error value of said reference clock signal lies below a lower, second error limit value and the error value of the other reference clock signal(s) has the same or a lower value.

3. Method according to one of the preceding claims, characterized in that the error values which are assigned to the reference clock signals (f_{RM}, f_{RB}) supplied to the clock circuit (A) are reduced by a predetermined value after the expiry of predetermined time units.

4. Apparatus for carrying out the method according to one of the preceding claims, comprising
the clock circuit (A) with
a device (PE) for testing the reference clock signals (f_{RM}, f_{RB}) supplied for clock errors and for evaluating the clock errors,
a table memory (TS) for storing the error values and a controller (MPC) to which a program for executing the method is assigned.

5. Apparatus according to Claim 4, characterized in that, in conjunction with a transmission path to a clock circuit of a further telecommunications exchange (B), the clock circuit (A) forms a reference clock source for said clock circuit.

## Revendications

1. Procédé de synchronisation d'un dispositif (A) d'horloge d'un système de commutation en télécommunication des premiers et seconds signaux (f_{RM}, f_{RB}) d'horloge de référence provenant d'une première et d'une seconde source (M, B) extérieures d'horloge et de référence, étant envoyés au moins temporairement à ce dispositif, une priorité prescrite étant associée à chaque source (M, B) extérieure d'horloge de référence, les premiers et seconds signaux (f_{RM}, f_{RB}) d'horloge de référence envoyés au dispositif (A) d'horloge par la première et la seconde source (M, B) d'horloge de référence étant vérifiés en ce que concerne des erreurs d'horloge propres à chaque première et seconde horloge de référence, des valeurs d'erreur par erreur de rythme étant affectées à ces erreurs de rythme, et le dispositif (A) d'horloge prenant en charge pour sa synchronisation le signal (f_{RM}, f_{RB}) d'horloge de référence fourni par la première ou la deuxième source (M, B) d'horloge de référence en fonction des priorités affectées aux sources (M, B) d'horloge de référence, et des valeurs d'erreur par erreur de rythme,
caractérisé en ce que,
le dispositif (A) d'horloge prend en charge pour sa synchronisation le signal (f_{RM}, f_{RB}) d'horloge de référence fourni par la première ou la deuxième source (M, B) d'horloge de référence, avec une valeur d'erreur par erreur de rythme, qui est petite, lorsque les priorités des sources (M, B) d'horloge de référence sont égales, et le dispositif (A) d'horloge prend en charge le signal (f_{RM}, f_{RB}) d'horloge de référence de la source (M) d'horloge de référence de plus grande priorité lorsque les priorités des sources (M, B) d'horloge de référence sont différentes, dans la mesure où le signal (f_{RM}) d'horloge de référence envoyé par cette source (M) d'horloge de référence ne dépasse pas une première valeur-limite supérieure prescrite d'erreur, et le dispositif d'horloge prend en charge le signal (f_{RB}) d'horloge de référence de la source (B) d'horloge de référence de priorité secondaire en cas de dépassement de cette valeur-seuil d'erreur, dans la mesure où le signal (f_{RB}) d'horloge de référence envoyé par la source (B) d'horloge de référence de priorité secondaire a une plus petite valeur d'erreur que le signal (f_{RM}) d'horloge de référence de priorité plus grande.

2. Procédé suivant la revendication 1,
caractérisé en ce que,
le dispositif (A) d'horloge conserve pour sa synchronisation le signal (f_{RB}, f_{RM}) horloge de référence fourni par la source (B, M) d'horloge de référence temporairement activée, en cas de priorités égales ou différentes des sources (M, B) d'horloge de référence, également lorsque la valeur d'erreur de ce signal de référence est plus petite qu'une deuxième valeur-limite inférieure d'erreur, et lorsque la valeur d'erreur du ou des autres signaux d'horloge de référence ont une valeur plus petite ou égale.

3. Procédé suivant l'une des revendications précédentes,
caractérisé en ce que,
les valeurs d'erreur, qui sont affectées aux signaux (f_{RM}, f_{RB}) d'horloge de référence envoyés au dispositif (A) d'horloge, sont diminuées d'une valeur prescrite après l'écoulement d'unités de temps prescrites.

4. Dispositif pour mettre en oeuvre le procédé suivant l'une des revendications précédentes,
constitué
du dispositif (A) d'horloge comportant
un dispositif (PE) destiné à contrôler les signaux (f_{RM}, f_{RB}) d'horloge de référence en ce qui concerne des erreurs de rythme, et à traiter les erreurs de rythme,
une mémoire (TS) de tableaux destinée à enregistrer les valeurs d'erreur et une commande (MPC), à laquelle est associé un programme de mise en oeuvre du procédé.

5. Dispositif suivant la revendication 4,
caractérisé en ce que,
le dispositif (A) d'horloge forme, en liaison avec une ligne de transmission en direction d'un dispositif d'horloge d'un autre système (B) de commutation en télécommunication, une source d'horloge de référence pour ce dispositif d'horloge.
